# EUROPEAN PATENT APPLICATION

(11) **EP 4 510 794 A1**
(43) Date of publication of application: **19.02.2025**
(21) Application number: 24191868.9
(22) Date of filing: 30.07.2024
(51) Int. Cl.: H05K 7/20

(54) **POWER MODULE, POWER SUPPLY SYSTEM AND VEHICLE**

(30) Priority: 15.08.2023 CN 202322210734 U
(71) Applicant: Valeo eAutomotive Shenzhen Co., Ltd, Shenzhen Guangdong 518128 (CN)
(72) Inventor: XU, Xiaoting, Shenzhen, 518128 (CN); XU, Kangfa, Shenzhen, 518128 (CN); HU, Dong, Shenzhen, 518128 (CN); QU, Gongyuan, Shenzhen, 518128 (CN)
(74) Representative: Valeo Powertrain Systems

(57) **Abstract**

The present invention relates to a power module, a power supply system and a vehicle. The power module comprises a housing (1) and a power device module (2). The power device module (2) is arranged in the housing (1) in a mounting direction (A), and the power device module (2) comprises: a first power device (3), the first power device (3) having a first heat generating surface (4) perpendicular to the mounting direction (A); and a heat dissipation member (6), which comprises a plurality of side walls (7) and an accommodating space (8) between the plurality of side walls (7) and penetrating along the mounting direction (A), the first power device (3) being accommodated in the accommodating space (8), wherein the first heat generating surface (4) of the first power device (3) directly contacts a bottom plate (11) of the housing (1).

## Description

### TECHNICAL FIELD

The present invention relates to a power module, a power supply system comprising such a power module, and a vehicle comprising such a power module or such a power supply system.

### BACKGROUND

An electric or hybrid vehicle has an electric drive assembly system, which needs to be powered by a power module, such as an on-board power module. With the popularity of more and more compact products on vehicles, a requirement for integrated and compact design of power modules has also emerged.

Generally, a power device module in a power module is arranged vertically in a housing of the power module, and a part of the housing in contact with the power device module is provided with a cooling circuit for dissipating heat from the power device module. However, the vertical height of such an arrangement is greater, and it is not possible to satisfy requirements for an integrated and compact design.

Therefore, it is necessary to arrange the housing and the power device module in a limited power module height, to satisfy the requirement for an integrated and compact design of a vehicle, while ensuring good heat dissipation performance.

### SUMMARY OF THE INVENTION

In view of the problem and requirement mentioned above, the present invention proposes a power module, a power supply system comprising such a power module, and a vehicle comprising such a power module or such a power supply system, which solve the above problem and bring about other technical effects by adopting the following technical features.

In one aspect, the present disclosure provides a power module, comprising a housing and a power device module. The power device module is arranged in the housing in a mounting direction, wherein the power device module comprises: a first power device, the first power device having a first heat generating surface perpendicular to the mounting direction; and a heat dissipation member, which comprises a plurality of side walls and an accommodating space between the plurality of side walls and penetrating along the mounting direction, the first power device being accommodated in the accommodating space, wherein the first heat generating surface of the first power device directly contacts a bottom plate of the housing.

Since a high-power element in a power device module, such as a transformer or inductor, generates a high temperature during operation, conventionally elements are placed in a heat dissipation member and potted with a thermally conductive adhesive, and then the heat dissipation member is mounted above a cooling passage of a housing; heat is transferred between a cover plate on the cooling passage and a bottom plate of the heat dissipation member, and heat emitted by the power element is thereby dispersed, so as to cool the power element. However, such a method requires a power element to transfer the heat thereof to a cooling medium by means of three layers of surfaces (that is, thermally conductive adhesive + heat dissipation member bottom plate + cooling passage cover plate), and the dimension in the height direction is greater, and the heat dissipation efficiency is low.

According to the above features, the present disclosure provides a solution for designing heat dissipation of a power module of a limited height. An existing heat dissipation member bottom plate is omitted in the height direction, and by means of the first heat generating surface of the first power device directly contacting the bottom plate of the housing, the existing three layers of surfaces are reduced to two layers of surfaces: the first heat generating surface and the bottom plate of the housing. Thus the dimension in the height direction is reduced.

It must be explained that the height direction referred to in the present disclosure may also be called the mounting direction, which is defined by the direction in which the power device module is mounted or fitted to the housing.

As an example, the power module proposed in the present disclosure may have a dimension in the height direction reduced by several millimetres, for example, 1.5 to 3 mm. This reduced amount in height is significant for the design of the power module. Since the space to optimize intrinsic dimensions of the housing, power elements, circuit board, etc. is limited, optimizing the dimension in the height direction by several millimetres allows the power module to be adapted to a more compact design requirement.

In some examples, in the mounting direction, the level of the bottommost part of the heat dissipation member does not exceed the first heat generating surface.

According to the above features, the first heat generating surface is at least flush with the bottommost part of the heat dissipation member, and even slightly exceeds the bottommost part of the heat dissipation member, so as to easily more fully contact the bottom plate of the housing, ensuring heat dissipation efficiency.

In some examples, the bottom plate defines a heat dissipation area, and the heat dissipation area protrudes away from the bottom plate towards the first power device, to closely adhere to the first heat generating surface.

According to the above features, the heat dissipation efficiency is likewise considered; the heat dissipation area of the bottom plate of the housing may be configured to protrude towards the first power device, so as to closely adhere to the first heat generating surface.

In some examples, the first power device further comprises a plurality of second heat generating surfaces that are parallel to the plurality of side walls, and the plurality of second heat generating surfaces directly contact the corresponding plurality of side walls.

According to the above features, to increase heat dissipation efficiency, the first power device may further dissipate heat through the plurality of side walls of the heat dissipation member in contact with the second heat generating surface.

In some examples, at least one of the plurality of side walls is provided with a cooling circuit, which is configured to allow a cooling medium to flow therethrough.

As an example, the cooling medium may be water, oil or an alcohol solution, such as ethylene glycol or propylene glycol.

In some examples, the cooling circuit and the second heat generating surface at least partially overlap in the mounting direction, to cool the second heat generating surface.

Generally, the heat dissipation member is arranged in a sealed space inside the housing, and air circulation or fluid circulation is generally not present in this sealed space; therefore, the efficiency of heat dissipation solely by heat radiating outwards from a side wall is generally not high, and it is necessary to provide an active heat exchange circuit to disperse heat conducted by the side wall.

According to the above features, at least one side wall is provided with a cooling circuit for a cooling medium to flow through, and heat may be better dispersed through the cooling medium. In cooperation with the above-described technical features of the present disclosure, an existing cooling circuit, which is arranged in the housing or arranged on the bottom part of the heat dissipation member, is rearranged in a side wall of the heat dissipation member, which not only can reduce the dimension in the mounting direction but also can ensure or even optimize heat dissipation efficiency of the power module.

In some examples, at least one of the plurality of side walls comprises an inner surface in contact with the corresponding second heat generating surface and an outer surface opposite the inner surface, wherein the power device module further comprises a second power device in contact with the outer surface.

According to the above features, the heat dissipation member also may further use the outer surface of the side wall that has the cooling circuit to dissipate heat, and for example, the outer surface is provided with the second power device in contact therewith.

In some examples, the first heat generating surface and the second heat generating surface comprise a surface of a potting compound of the first power device.

According to the above features, the first power device may be sealed with the potting compound; for example, first, the first power device is fixed in a potting mould, and the potting compound is poured into the mould and cured, so that the potting compound and the first power device integrally form a single piece. The potting compound, for example, may be a cube or a cuboid, and a lower surface thereof forms a first heat generating surface, and a side surface thereof forms a second heat generating surface. The potting compound, for example, may be a curable thermally conductive adhesive.

In some examples, the power device module further comprises a second power device, and the second power device is pressed against the outer surface of the side wall through a pressing strip.

According to the above features, the pressing strip may press the second power device against the outer surface of the side wall, ensuring the second power device adheres closely to the outer surface.

In some examples, the second power device is a power transistor device, such as an IGBT power transistor (an insulated-gate bipolar transistor), a MOS transistor or another transistor.

In some examples, the power device module further comprises a mounting bracket, and the first power device is mounted by the mounting bracket in the accommodating space of the heat dissipation member in a suspended manner.

In some examples, the first power device is a transformer or an inductive element.

According to the above features, the first power device, for example, may be a transformer or an inductive element, the size thereof is larger and the amount of heat emitted is also greater. The second power device may be a power transistor device, and a side wall having a cooling circuit may be fully adhered thereto.

In some examples, the power device module is detachably connected to the housing.

According to the above features, the power device module and the housing are respectively independent components, and detachably connected to each other; the housing may have a simple structure, without requiring a complicated die casting process.

In another aspect, the present disclosure provides a power supply system comprising the power module as described above. Since all the technical features of the power module as described previously are comprised, the power supply system also has corresponding technical effects and advantages.

In another aspect, the present disclosure provides a vehicle comprising the power module described above or comprising the power supply system described above.

### BRIEF DESCRIPTION OF THE DRAWINGS

FIG. 1 shows a three-dimensional view of a power module according to at least one embodiment of the present disclosure, wherein a housing is omitted;
FIG. 2 shows an exploded view of the power module shown in FIG. 1;
FIG. 3 shows a bottom view of the power module shown in FIG. 1;
FIG. 4 shows an exploded view of the power module according to at least one embodiment of the present disclosure;
FIG. 5 shows a partial sectional view of a power module according to at least one embodiment of the present disclosure;
FIG. 6 shows an enlarged view of the dotted line portion in FIG. 5;
FIG. 7 shows an exploded view of a power device module according to at least one embodiment of the present disclosure.

### DETAILED DESCRIPTION

In order to clarify the objective, technical solution and advantages of the present disclosure, the technical solution of embodiments of the present disclosure is described clearly and completely below in conjunction with the drawings accompanying particular embodiments of the present disclosure. In the drawings, identical reference numerals denote identical parts. It must be explained that the embodiments described are some, not all, of the embodiments of the present disclosure. All other embodiments obtained by those skilled in the art based on the described embodiments of the present disclosure without the need for inventive effort shall fall within the scope of protection of the present disclosure.

Unless otherwise defined, the technical or scientific terms used herein shall have the common meanings understood by those skilled in the art. The words "first", "second", and the like used in the description and claims of the patent application disclosed herein do not indicate any order, quantity or importance, being merely used to distinguish different component parts. Likewise, words such as "a" or "one" do not necessarily represent a quantity limit. "Comprise" or "include" or similar words mean that the element or object appearing before the word encompasses the elements or objects and their equivalents listed after the word, without excluding other elements or objects. Words such as "connect" or "link" are not restricted to a physical or mechanical connection, and may include an electrical connection, whether direct or indirect. The terms "upper", "lower", "left", "right" and the like are only used to indicate the relative positional relationship, and when the absolute position of a described object changes, the relative positional relationship may also change accordingly.

Generally, a power device module in a power module is arranged vertically in a housing of the power module, and a part of the housing in contact with the power device module is provided with a cooling circuit for dissipating heat from the power device module. However, such an arrangement requires a power element to transfer the heat thereof to a cooling medium by means of three layers of surfaces (that is, thermally conductive adhesive + heat dissipation member bottom plate + cooling passage cover plate), and the dimension in the height direction is greater, and the heat dissipation efficiency is low; it is not possible to satisfy requirements for an integrated and compact design.

In addition, it is necessary to design a complicated water channel circuit in existing housings, and adhere the power device to the housing to achieve a heat dissipation effect. Such an arrangement causes devices to be scattered with a motley criss-crossing of connecting lines, and the overall functional module is enormous; moreover, a lot of space is taken up in the housing with the result that the product housing is larger, and machining is complicated and difficult. Moreover, the overall assembly of the product is more difficult; each device must be assembled one-by-one, the procedure is complicated and the efficiency is not ideal.

Regarding defects of the prior art, the present disclosure proposes a power module, a power supply system comprising the power module, and a vehicle comprising the power module or the power supply system.

An object of the present disclosure is to provide a power module without a heat dissipation member bottom plate, reducing a mounting direction dimension. In addition, the heat dissipation member may further be provided with a cooling circuit for a cooling medium to flow through, and two sides of a side wall are heat dissipation areas. A power device module is placed in the heat dissipation member, and is filled with a highly thermally conductive adhesive for transferring heat. Heat only needs to be transferred to the cooling medium by means of two layers of conductors, reducing the thermal resistance of one layer of a metal wall. The design of a heat sink without a heat dissipation member bottom plate can reduce the weight of parts in the height direction. Moreover, the thermally conductive adhesive can directly bond to the housing, creating natural cooling and reducing the thermal resistance of a bottom metal wall.

Preferred embodiments of the power module, power supply system and vehicle according to the content of the present disclosure are specifically explained below in conjunction with the drawings.

Compared with the embodiments shown in the drawings, a feasible embodiment within the scope of protection of the present disclosure may have fewer components, another component not shown in any of the drawings, a different component, a component arranged differently, or a component connected differently, etc. Further, without departing from the concepts disclosed in the present disclosure, two or more components in a drawing may be implemented in a single component, or a single component shown in a drawing may be implemented as a plurality of separate components.

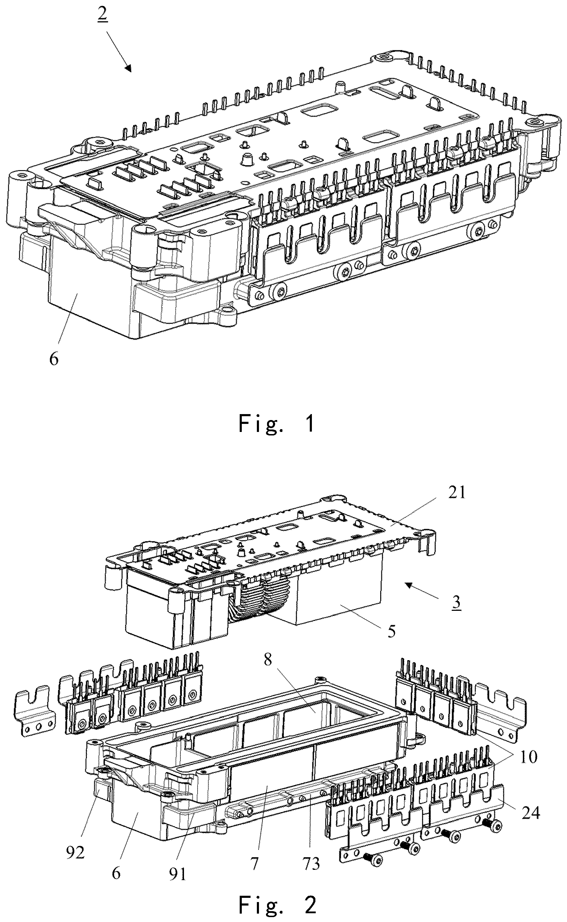

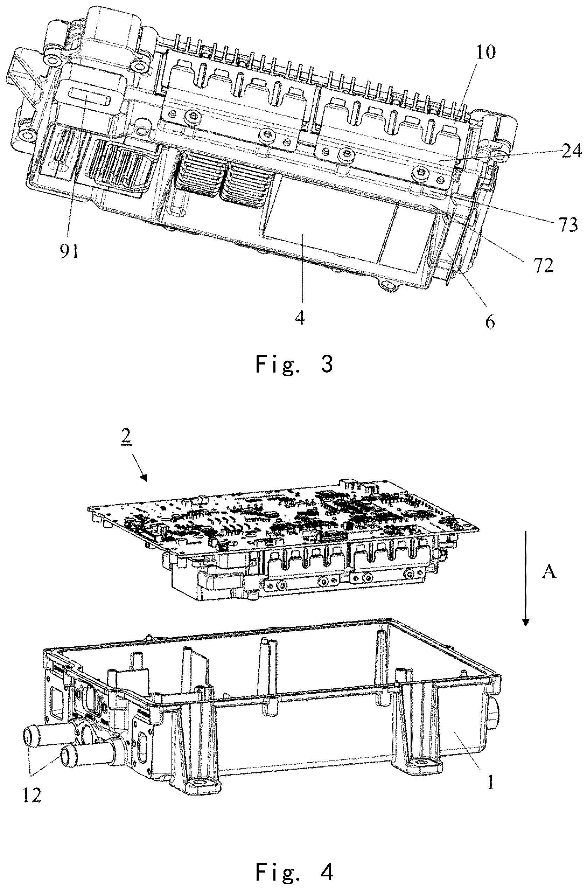

Figs. 1 to 4 show a power module according to at least one embodiment of the present disclosure, used for providing power to an electric drive assembly system of an electric or hybrid vehicle, the power module comprising a housing 1 and a power device module 2, and the power device module 2 being arranged in the housing 1 in a mounting direction A. The mounting direction A is defined as the direction from top to bottom in Fig. 4. The housing 1 is formed by a die casting process. The housing 1 can be provided without any cooling circuit.

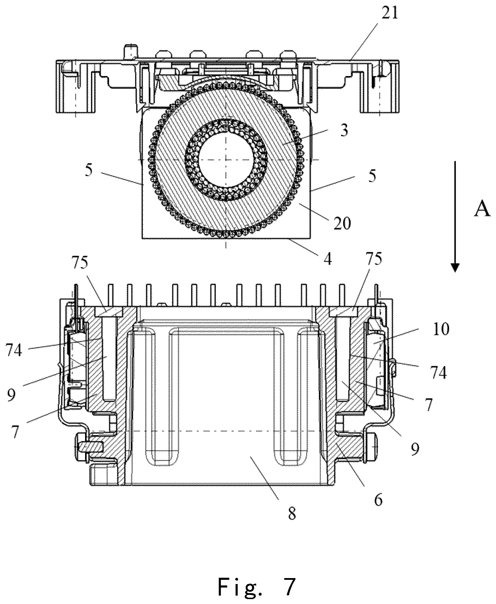

As shown in Fig. 2, the power device module 2 specifically may comprise a first power device 3, a second power device 10, a heat dissipation member 6 and a mounting bracket 21. The first power device 3 is fixedly connected to the mounting bracket 21, and is mounted in the heat dissipation member 6 in a suspended manner by the mounting bracket 21, as shown in Fig. 7.

Optionally, as shown in Fig. 4, the power device module 2 may further comprise a circuit board assembly that is arranged on the mounting bracket 21.

In the present embodiment, the power device module 2 is detachably connected to the housing 1, for example, being connected by a screw. Alternatively, the heat dissipation member 6 and/or the mounting bracket 21 of the power device module 2 may also be integrally formed with the housing 1, for example, being formed by integral die casting.

In the description of an embodiment below, the first power device is a transformer or an inductive element, and the second power device may be a power transistor device, for example in the present embodiment, an IGBT power transistor. Alternatively, the first power device also may be another heat generating element of a larger size, such as a capacitor. The second power device also may be another heat generating element of a smaller size, such as a chip capacitor or chip resistor.

The first power device 3 is provided with a first heat generating surface 4 perpendicular to the mounting direction A. In the present embodiment, regarding the first power device 3, by means of sealing and curing by a thermally conductive potting compound 20, a bottom face of the potting compound 20 forms the first heat generating surface 4, and a side face of the potting compound 20 forms a second heat generating surface 5. Heat generated during operation of the first power device 3 is dispersed outwards through the first heat generating surface 4 and the second heat generating surface 5.

Alternatively, the first power device 3 may also not comprise the potting compound 20, and directly contact a bottom plate 11 of the housing 1 or contact the bottom plate through an insulating thermally conductive member.

Again referring to Fig. 2, the heat dissipation member 6 comprises a plurality of side walls 7 and an accommodating space 8 between the side walls 7 and penetrating along the mounting direction A, and the first power device 3 is accommodated in the accommodating space 8. At least one of the plurality of side walls 7 may be provided with a cooling circuit 9, and the cooling circuit 9 is configured to allow a cooling medium to flow therethrough.

Since the heat dissipation member 6 is penetrated, it is possible for the heat dissipation member 6 in embodiments of the present disclosure to not comprise a bottom plate, and the first power device 3 directly contacts the bottom plate 11 of the housing 1.

The first power device 3 further comprises a plurality of second heat generating surfaces 5 that are parallel to the plurality of side walls 7, and the plurality of second heat generating surfaces 5 directly contact the corresponding plurality of side walls 7.

At least one of the plurality of side walls 7 comprises an inner surface 71 contacting the corresponding second heat generating surface 5 and an outer surface 72 opposite the inner surface 71. As shown in Figs. 2 and 3, the outer surface 72 may be provided with a mounting part 73; the mounting part 73 protrudes outwards from the outer surface 72, and is provided with threaded holes used for mounting a pressing strip 24. The pressing strip 24 has a bent shape, adapted to the thickness of the second power device 10, so that the second power device 10 may be fitted onto the outer surface 72.

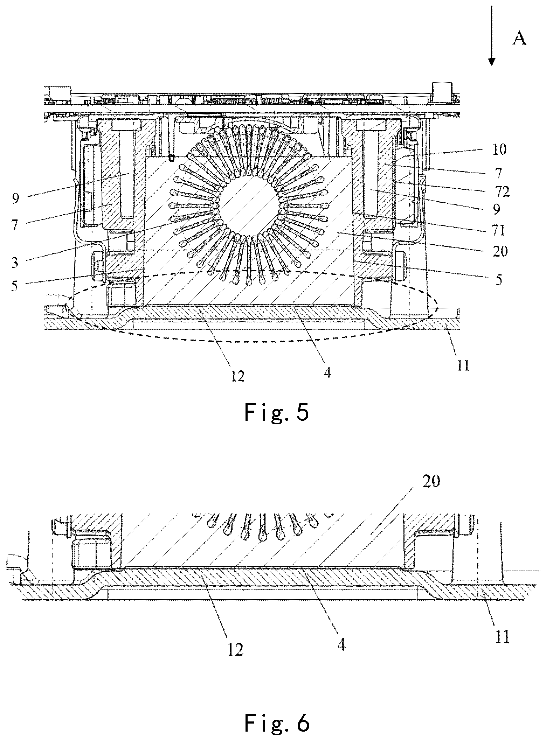

A mounting state of the first power device 3 and the second power device 10 is described below with reference to Figs. 5 to 7.

First, reference is made to Fig. 7 which shows an exploded view of the power device module 2. Before assembly of the heat dissipation member 6 and the first power device 3, firstly, the second power device 10 may be mounted on a side wall 7 of the heat dissipation member 6, and the first power device 3 is mounted on the mounting bracket 21 in a suspended manner. Next, the mounting bracket 21, together with the first power device 3, is placed in the accommodating space 8 along the mounting direction A.

At least one of the plurality of side walls 7 of the heat dissipation member 6 is provided with a cooling circuit 9, which is configured to allow a cooling medium to flow therethrough. The cooling circuit is enclosed and formed by a channel 74 machined on the side wall 7 and a cover plate 75 that seals the channel 74. The cover plate 75 is connected to the channel 74 by welding.

Optionally, the heat dissipation member 6 further may be provided with an inlet 91 and an outlet 92 of the cooling circuit 9; correspondingly, the housing 1 is also provided with interfaces 12 connected to the inlet 91 and the outlet 92, and the interfaces 12 may be in fluid connection with an external cooling pipeline. Alternatively, the functions of the inlet 91 and the outlet 92 may be interchanged.

Referring to Fig. 5, the cooling circuit 9 and the second heat generating surface 5 of the first power device 3 at least partially overlap in the mounting direction A, to cool the second heat generating surface 5. Similarly, a mounting position of the second power device 10 is such that the second power device at least partially overlaps the cooling circuit 9 in the mounting direction A.

Again referring to Figs. 5 and 6, the first heat generating surface 4 of the first power device 3 directly contacts the bottom plate 11 of the housing 1. Optionally, in the present embodiment, in the mounting direction A, the level of the bottommost part of the heat dissipation member 6 does not exceed the first heat generating surface 4, which can be seen in the partial enlarged view in Fig. 6.

To increase the closeness with which the bottom plate 11 adheres to the first heat generating surface 4, the bottom plate 11 defines a heat dissipation area 12, and the heat dissipation area 12 protrudes away from the bottom plate 11 towards the first power device 3, to closely adhere to the first heat generating surface 4. This protruding portion of the heat dissipation area 12 may be formed by stamping, for example. It must be highlighted that, although cured, the potting compound 20 still has a certain elasticity and plasticity, and can appropriately be compressed and deform; therefore, such close fitting contact is feasible.

In another aspect, the present invention also proposes a power supply system, comprising the power module as described above. The power supply system is used, for example, to supply power to electric or hybrid vehicles.

According to another aspect of the present disclosure, a vehicle is proposed, the vehicle comprising the power module as described above or the power supply system as described above, and having the function as described above. The vehicle may be an electrified vehicle, such as a battery electric vehicle (BEV), a hybrid electric vehicle (HEV), a plug-in hybrid electric vehicle (PHEV), a range extended EV and a fuel cell electric vehicle (FCEV). The vehicle may also be a hydrogen-powered vehicle.

Exemplary embodiments of a power module, a power supply system and a vehicle of the present invention have been described in detail herein with reference to preferred embodiments. However, those of ordinary skill in the art will understand that, without departing from the concept of the present invention, various alterations and modifications may be made to the specific embodiments described above, and that various combinations of the technical features and structures proposed by the present invention may be made without exceeding the scope of protection of the present invention; the scope of protection of the present invention is defined by the attached claims.

## Claims

1. A power module, comprising a housing (1) and a power device module (2), wherein the power device module (2) is arranged in the housing (1) along a mounting direction (A), **characterized in that** the power device module (2) comprises:
a first power device (3) having a first heat generating surface (4) perpendicular to the mounting direction (A); and
a heat dissipation member (6), which comprises a plurality of side walls (7) and an accommodating space (8) between the side walls (7) and penetrating along the mounting direction (A), and the first power device (3) is accommodated in the accommodating space (8),
wherein the first heat generating surface (4) of the first power device (3) directly contacts a bottom plate (11) of the housing (1).

2. The power module according to Claim 1, **characterized in that**, along the mounting direction (A), the level of the bottommost part of the heat dissipation member (6) does not exceed the first heat generating surface (4).

3. The power module according to Claim 2, **characterized in that** the bottom plate (11) defines a heat dissipation area (12), and the heat dissipation area (12) protrudes away from the bottom plate (11) towards the first power device (3) to closely adhere to the first heat generating surface (4).

4. The power module according to Claim 1, **characterized in that** the first power device (3) further comprises a plurality of second heat generating surfaces (5) parallel to the plurality of side walls (7), and the plurality of second heat generating surfaces (5) directly contact the corresponding plurality of side walls (7).

5. The power module according to Claim 4, **characterized in that** at least one of the plurality of side walls (7) is provided with a cooling circuit (9) configured to allow a cooling medium to flow therethrough.

6. The power module according to Claim 5, **characterized in that** the cooling circuit (9) and the second heat generating surface (5) at least partially overlap in the mounting direction (A) to cool the second heat generating surface (5).

7. The power module according to Claim 6, **characterized in that** at least one of the plurality of side walls (7) comprises an inner surface (71) contacting the corresponding second heat generating surface (5) and an outer surface (72) opposite the inner surface (71), wherein the power device module (2) further comprises a second power device (10) in contact with the outer surface (72).

8. The power module according to any one of Claims 4 to 7, **characterized in that** the first heat generating surface (4) and the second heat generating surface (5) comprise a surface of a potting compound (20) of the first power device (3).

9. The power module according to Claim 1 or 7, **characterized in that** the power device module (2) further comprises a second power device (10), and the second power device (10) is pressed against the outer surface (72) of the side wall (7) through a pressing strip (24).

10. The power module according to Claim 9, **characterized in that** the second power device is an IGBT power transistor.

11. The power module according to Claim 1, **characterized in that** the power device module (2) further comprises:
a mounting bracket (21), through which the first power device (3) is hung and mounted into the accommodating space (8) of the heat dissipation member (6).

12. The power module according to Claim 1, **characterized in that** the first power device is a transformer or an inductive element.

13. The power module according to Claim 1, **characterized in that** the power device module (2) is detachably connected to the housing (1).

14. A power supply system, **characterized by** comprising the power supply module according to any one of Claims 1 to 13.

15. A vehicle **characterized by** comprising the power module according to any one of Claims 1 to 13 or the power supply system according to Claim 14.
